# EUROPEAN PATENT SPECIFICATION

(11) **EP 2 558 822 B1**
(45) Date of publication and mention of the grant of the patent: **16.09.2015**
(21) Application number: 11719048.8
(22) Date of filing: 15.04.2011
(51) Int. Cl.: G01D 5/20, G01B 7/30, G01R 23/07, G01B 7/00

(54) **AN ELECTROMAGNETIC METHOD FOR SENSING THE RELATIVE POSITION OF TWO ITEMS USING COUPLED TUNED CIRCUITS**
ELEKTROMAGNETISCHES VERFAHREN ZUR ERFASSUNG DER RELATIVEN POSITION VON ZWEI ELEMENTEN ANHAND VON GEKOPPELTEN ABGESTIMMTEN SCHALTUNGEN
PROCÉDÉ ÉLECTROMAGNÉTIQUE POUR LA DÉTECTION DE LA POSITION RELATIVE DE DEUX ARTICLES À L'AIDE DE CIRCUITS COUPLÉS ACCORDÉS

(30) Priority: 15.04.2010 GB 201006301
(43) Date of publication of application: 20.02.2013
(73) Proprietor: AND Technology Research Limited, Theydon Bois, Essex CM16 7EY (GB)
(72) Inventor: THORN, John, Theydon Bois Essex CM16 7EY (GB)
(74) Representative: Warren, Caroline Elisabeth
(86) International application number: PCT/GB2011/050751
(87) International publication number: WO 2011/128698

(56) References cited:
- EP-A2- 1 455 454
- GB-A- 2 286 679
- US-A- 3 852 662
- US-A- 4 608 564
- US-A- 4 642 786
- US-A1- 2002 140 419

## Description

This invention relates to a method for sensing the relative position (and therefore movement) of two items even when they are physically separated. An example application would be to convey the movement of the impeller or turbine in a water meter to the electronic register that counts its rotations. The turbine or impeller is in the water flow, but it is advantageous for the register electronics to be dry i.e. outside the water flow, so there must be inevitably a barrier between the impeller and the register, and the movement of the impeller must be sensed accurately by the register despite the physical separation across this barrier.

The present invention proposes a method using tuned resonant circuits; i.e. circuits that resonate at a particular frequency and include inductive and capacitive parts; Embodiments of the method find particular application in detecting the movement of water and other fluids..The proposed method involves using the movement to vary the coupling between a tuned resonant circuit attached to one item and a tuned resonant circuit with a close (but not necessarily exactly identical) resonant frequency attached to the other item. The proposed method involves directly driving one circuit so that it is excited at a frequency close to or at its resonance. Changes in the coupling between this directly driven circuit and the other (non driven) circuit have an effect on how the oscillations in the driven circuit vary with time and this time variation in the oscillation is analysed by detector electronics and used to determine the coupling and therefore the relative position.

US-A1-2002/0140419 describes a short distance positioning system for a mobile object equipped with a resonant circuit enabling reception and retransmission of a magnetic field.

US-B-4,642,786 describes a method and apparatus for position and orientation measurement using a magnetic field and retransmission thereof from a plurality of passive resonant circuits acting as retransmitters.

GB-A-2286679 describes an absolute position detection apparatus, including sine and cosine wave generators, and error compensation methods therefor.

The present invention differs from prior art such as described in US 2002/0140419 A1 in that it specifically detects a phenomenon which occurs as the energy in a the second circuit initially builds up immediately after the drive is applied to the first and before the steady state is established. The phenomenon is an initial rise in the amplitude of the driven circuit followed by a fall.

The present invention allows the relative position of the items to be sensed in a way which can be very fast, can consume very little power, can be easy to manufacture, can be reliable, can be accurate, can be immune to tamper, can minimise significant external electrical or magnetic fields and in which the essential components can be light and can be made at low cost. Further, embodiments of the system minimise the calibration required, since they rely on the relative, and not absolute, positions of meter components.

Preferably the coupling varying means can be implemented by arranging that the magnetic flux linkage between the inductive parts of the driven and the non-driven tuned circuits varies as they move relative to each other.

Preferably the inductive parts of the driven tuned circuit will comprise a number of regions in which the magnetic flux generated in any region by the current flowing in the tuned circuit will be in the opposite direction to that generated by the same current flowing through other regions. Preferably the regions will be such that at any significant distance away, the components of the magnetic flux that are generated from the different regions cancel so that the net external flux drops very rapidly as the distance from the circuits increases.

Preferably the inductive parts of the non driven tuned circuit will also comprise a number of regions in which the magnetic flux generated in any region by any current flowing in the tuned circuit will be in the opposite direction to that generated by the same current flowing through other regions. Preferably the regions will be such that at any significant distance away, the components of the flux that are generated from the different regions cancel so that the net external flux drops very rapidly as the distance from the circuits increases. A further advantage of such an arrangement is that external fields applied from any significant distance will induce close to equal and opposite electro-magnetic forces (e.m.f.s) in these regions and consequently the net e.m.f.s induced in the inductors comprising the tuned circuits will be close to zero making the operation of the detector highly immune to tamper with external fields.

Preferably the inductive parts of the tuned circuits will be such as not to require any ferrite or other high permeability material. Avoiding such materials will further increase the immunity to tamper by removing the possibility for the operation to be altered by saturating these materials with high externally applied magnetic fields.

Preferably some or all of the inductive parts of the tuned circuits can be implemented directly by appropriate printed circuit track layouts.

Preferably the electronics will be such that it can sense the coupling intermittently so as to produce a series of samples of the relative rotational position of the elements whilst allowing the detector to be turned off between samples. This allows the average power consumption required to be minimised.

Preferably the tuned circuits will be such that the resonant frequencies are high, as this reduces the time taken to establish the coupling in any one sample, and therefore further minimises the average power consumption for a given sample rate.

In a preferred embodiment, the exciting waveform is in the form of a burst of pulses at or close to the resonant frequency. The frequency of pulses is preferably significantly higher than the expected rotation frequency of the circuits.

When used to sense rotational movement, preferably the electronics will be configured so that it can drive and excite two of the driven tuned circuits separately and these two circuits will be arranged so that they can both sense the relative rotation of the same non-driven circuit and arranged so that the maximum coupling for one driven circuit to the non-driven circuit occurs at a different rotational position to that for the other driven circuit to the non-driven circuit. Preferably the positions of these two maxima will be approximately 45 degrees apart. This would allow the use of a quadrature decoder to sense the direction of the rotation and to count rotations.

Preferably the drive and sensing circuitry can be configured as logic blocks to be incorporated within a microcontroller in order to minimise physical size, power consumption and maximise speed of operation.

Preferably the two driven circuits can arranged so that they can be attached one in a fixed position and the other in a free rotating position but allowing for a barrier between them.

Preferable the two driven circuits can be arranged so that the distance across the barrier can be adjusted to obtain optimal results in any one instance.

An example of the invention will now be described by referring to the accompanying drawings:
Figure 1 shows an example of two items at one relative rotational position to one another - where the coupling between the tuned circuits is at a maximum.
Figure 2 shows the same items at a different relative rotational position - where the coupling between the tuned circuits is at a minimum.
Figure 3 shows how the coupling between the tuned circuits varies with the rotational position of the items.
Figure 4 shows an example of printed circuit board tracking that could be used for either or both of the tuned circuits.
Figure 5 shows the effect of the coupling on the build up of oscillations in the driven tuned circuit.
Figure 6 shows an example configuration of electronics that could be used to detect the variations in coupling.
Figure 7 shows another example configuration of electronics that could be used to detect the variations in coupling.
Figure 8 shows an example of digital and analogue electronic blocks that can be incorporated with a microprocessor to provide the necessary drive and sensing capability.
Figure 9 shows a visualisation of a free rotating tuned circuit based on PCB technology.
Figure 10 shows a visualisation of fixed position tuned circuit based on PCB technology.
Figure 11 shows the results of testing to provide optimal performance of sensing across differing barrier distances and using differing sizes of coils.

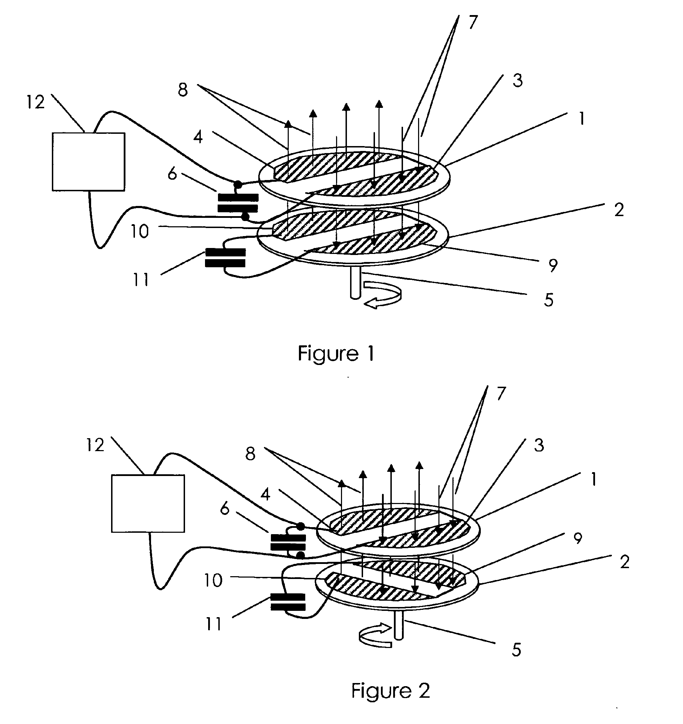

Figures 1 and 2 both show the two items 1 and 2 whose relative rotational position is being sensed. In this example it is assumed that item 1 is fixed and item 2 may rotate about an axis 5 through its centre.

The areas 3, 4, 9 and 10 shown hatched are inductive elements and in this example are approximately semicircular in form.

The elements 3 and 4 are connected in series and are also connected to capacitor 6 to form the driven tuned circuit. The elements 9 and 10 are similarly connected in series and are also connected to capacitor 11 to form the non-driven tuned circuit.

Both tuned circuits have close (although not necessarily identical) resonant frequencies. The resonant frequencies of the circuits are close enough that an excitation signal in one circuit induces a resonant e.m.f. in the other circuit when the circuits are coupled.

A set of electronics 12 is connected to the tuned circuit based on elements 3 and 4. This set of electronics has two functions. It provides an excitation signal to create oscillation at or close to resonance in the tuned circuit and it also senses some aspects of the way this resultant oscillation varies with time.

The elements 3 and 4 are designed and connected in series in such a way that when a current flows through 3 so as to generate a magnetic field in one direction as shown by the arrows 7, the same current that flows through 4 because it is connected in series with element 3 will generate a similar field in the opposite direction as shown by the arrows 8. The inductive elements 9 and 10 are designed and connected such that in the rotational position shown in figure 1, the direction of any e.m.f. induced in 9 by an increase in the field shown by the arrows 7 will be added to the e.m.f. induced in 10 by an increase in the field shown by arrows 8. In the rotational position shown in figure 1 the effective coupling between the tuned circuits will therefore be at a maximum.

Figure 2 shows the situation when item 2 has been rotated through 90 degrees. Now only half the field created by current in 3 passes through element 9 and the other half passes through element 10. The e.m.f.s generated in 9 and 10 by changes in the current in 3 will now be in opposite directions and will therefore subtract and not add. Changes in the field generated by current in 4 will similarly generate e.m.f.s in opposing directions in elements 9 and 10. It follows that in this position the effective coupling between the tuned circuits will be a minimum. In the limit, if the arrangements are appropriately symmetrical the e.m.f.s induced will cancel completely and the consequent effective coupling will be zero.

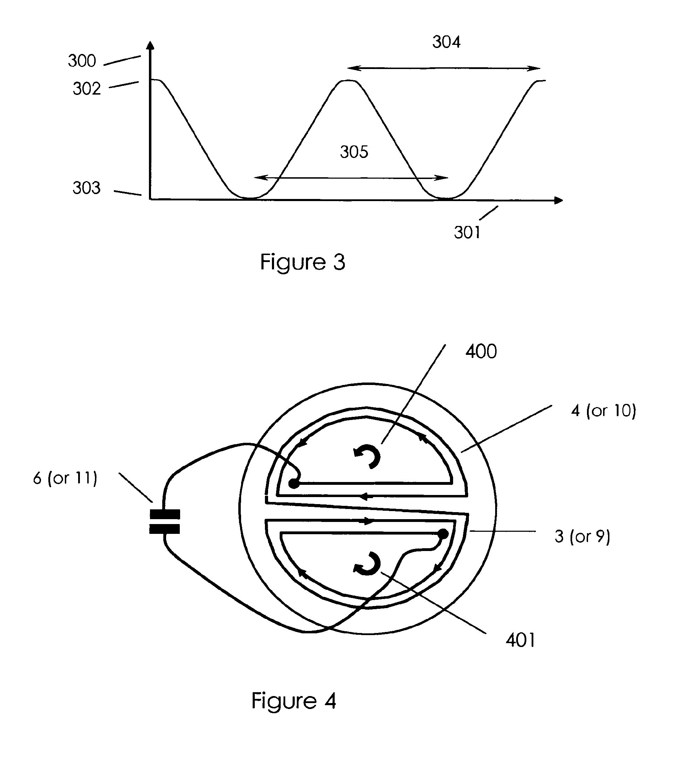

Figure 3 shows in stylised form how the effective coupling between the two tuned circuits in the configuration shown in figures 1 and 2 varies with relative rotation of items 1 and 2. In this figure the vertical axis 300 shows the degree of coupling between the two tuned circuits and the horizontal axis 301 shows the rotation between the two items. The coupling varies cyclically between a maximum 302 and a minimum 303. The angle between two consecutive positions of maximum coupling is shown in the figure as line 304 will be 90 degrees. This will also equal the angle between two consecutive positions of minimum coupling (line 305).

Figure 4 shows in stylised form a possible arrangement of printed circuit board tracks that can generate an appropriate anti-symmetrical field pattern and that therefore can be a possible embodiment of the inductive element pair 3 and 4 and of the pair 9 and 10. It also shows how the tracks would be connected to the capacitor 6 (or 11) to form the tuned circuit. The circular arrows 400 and 401 show the direction of circulating current and it can be seen that with the tracks connected as shown the current rotates in opposite directions in the two halves, giving rise to magnetic fields in opposite directions in the two halves.

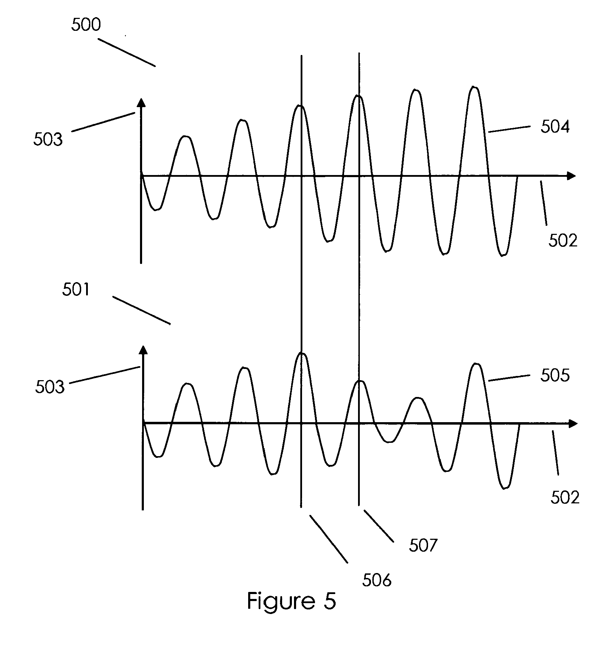

Figure 5 shows two graphs which illustrate in stylised form how the oscillations in the driven tuned circuit vary with time when an excitation signal at or close to the resonant frequencies of the circuits is applied. The vertical axis 503 in both graphs shows voltage across the driven tuned circuit and the horizontal axis 502 in both graphs shows time. Trace 504 in graph 500 shows what happens when the coupling is low or zero. In this case oscillations grow with time, eventually settling to a constant maximum amplitude. Trace 505 in graph 501 shows what happens when the coupling is high. In this case, oscillations grow initially but then reduce again after a few cycles. By sampling the voltage at two appropriate sampling times such as 506 and 507, and comparing these two voltages the degree of coupling can be ascertained - in the low coupling case the voltage at sample point 507 will be higher than that at sample point 506 and in the high coupling case it will be lower. The sign of the change in voltage between the two sample points provides a clearly distinguishable difference between the high and low coupling cases and consequently, the relative position of the items.

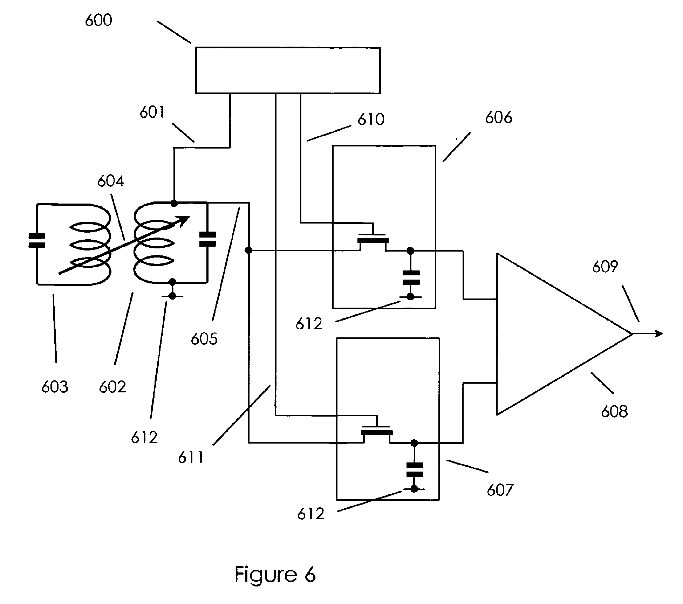

Figure 6 shows a block diagram of one configuration of electronics that can perform the necessary discrimination. A control and sequencing element 600 provides an excitation signal through connection 601 to one end of the driven tuned circuit 602, the other end of which is connected to the zero volt circuit node 612. The arrow 604 indicates the varying degree of coupling between the driven tuned circuit 602 and the non-driven tuned circuit 603. The voltage waveform created across the driven tuned circuit 602 is passed via connection 605 to two sample and hold circuits illustrated by blocks 606 and 607. The control and sequencing element 600 generates control signals 610 and 611 respectively to these so that they can sample this waveform at the points 506 and 507 respectively as shown in figure 5. The held samples are then compared by the comparator element 608, to generate a digital output at 609.

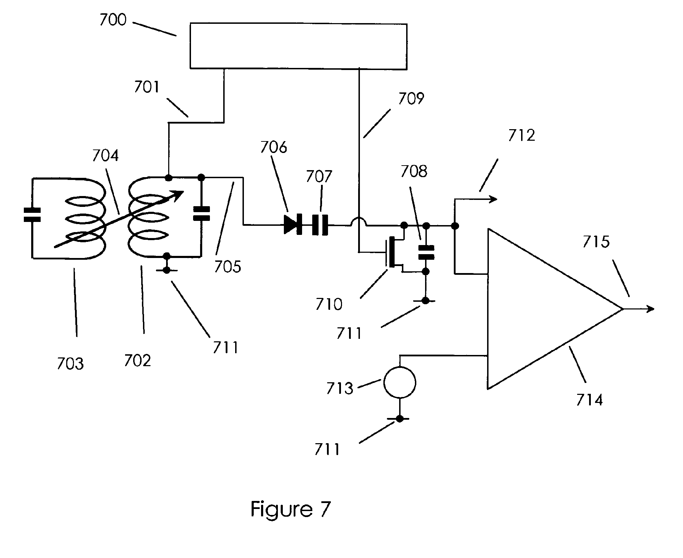

Figure 7 shows a block diagram of another configuration of electronics that can perform the necessary discrimination. A control and sequencing element 700 provides an excitation signal through connection 701 to one end of the driven tuned circuit 702, the other end of which is connected to the zero volt circuit node 711. The arrow 704 indicates the varying degree of coupling between the driven tuned circuit 702 and the non-driven tuned circuit 703. The voltage waveform created across the driven tuned circuit 702 with respect to the circuit zero voltage node 711 is passed via connection 705 and via a diode 706 in series to two capacitors 707 and 708. The sequencing element 700 can activate a switching means illustrated by FET 710 by driving the switch control signal 709. When the signal 709 is active the switch 710 provides a low resistance path to the circuit zero voltage node 711 that prevents capacitor 708 from charging significantly. The sequencing element 700 generates an excitation signal at or close to the resonant frequencies of circuits 702 and 703, resulting in a waveform across the tuned circuit similar to those shown in Figure 5. For the first cycles of this waveform in which the oscillation always grows regardless of the level of coupling 704, the sequencing unit holds the signal 709 active, and then drives it inactive for the subsequent cycles. This means the switch 710 will be on (low resistance) for the initial cycles of the oscillation and it follows that as the waveform grows each new peak of the waveform will charge capacitor 707 to the new peak voltage (less any inevitable diode drop across diode 706). When the control signal 709 goes inactive and switch 710 turns off what happens will depend on whether the oscillation grows or shrinks. If the waveform continues to grow as shown in graph 500, then each new peak (less the diode drop across diode 706) will exceed the voltage left by previous peaks on capacitor 707 and further charging current will flow, causing some charge to accumulate in capacitor 708. If on the other hand the waveform shrinks the new peaks (less the diode drop across diode 706) will not exceed the voltage on capacitor 707 and no further charging current will flow, so capacitor 708 will remain discharged. The resulting voltage across capacitor 708 can be used directly as an output 712 to gain an indication of the degree of coupling 704. Alternatively the voltage can be compared with a fixed voltage reference level 713, relative to the circuit zero voltage node 711, by a comparator 714 to give a digital output 715.

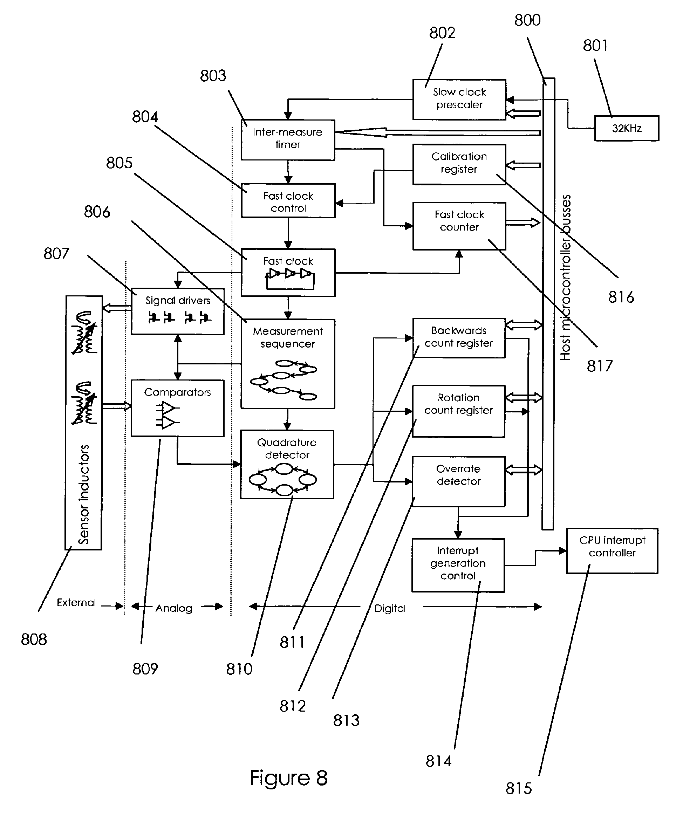

Figure 8 shows a block diagram of an example configuration of analogue drive and sensing blocks and digital drive and sensing blocks, which could be incorporated within a microcontroller and connected to the microcontroller's busses (800) . The busses would allow the microcontroller software to set values into and/or read values back from, the various blocks. The internal 32KHz oscillator (801) within the microcontroller is fed to a prescaler (802) which divides the frequency to feed an inter-measure timer (803) which is used to time the gaps between the intermittent measurements of position. When triggered by a pulse output from the inter-measure timer, the fast clock control (804) starts the fast timer (805). The fast timer feeds the measurement sequencer (806) which controls the generation of the drive and sampling signals that drive the analogue driving blocks (807) and analogue sensing blocks (809). These interact with the tuned circuits (808) which are external to the microcontroller. The resulting digital sampled signals are processed by the quadrature decoder (810) to detect rotations in either direction. The quadrature detector updates registers holding the total count (812) and a backward count (811). It also updates an overrate detector (813) which detects when the rate of rotation is such that a faster rate of sampling is required to avoid missing rotations by aliasing. When this is necessary or when either of the counts is close to overflow an interrupt for the microcontroller is generated by the interrupt generation control (814) and passed through to the microcontroller CPU interrupt controller (815) to cause the microcontroller software to collect the data from the count registers or increase the sampling rate by writing a new value to and thereby altering the behaviour of the inter-measure timer. When appropriate the microcontroller can also set the calibration register (816) so as to alter the behaviour of the fast clock control (805) so as to cause the fast clock counter (817) to accumulate the number of fast clock cycles that occur during a known number of 32 KHz clock cycles. The 32 KHz oscillator will be crystal controlled and will therefore be accurate. This mechanism therefore allows the microcontroller software to calculate the frequency of the fast clock and adjust this if necessary by adjusting the value written to the calibration register (816). This enables the software to ensure that the drive generated by the fast clock will remain sufficiently close to the resonant frequency of the tuned circuits, even if the detailed behaviour of the fast oscillator alters with age or temperature etc..

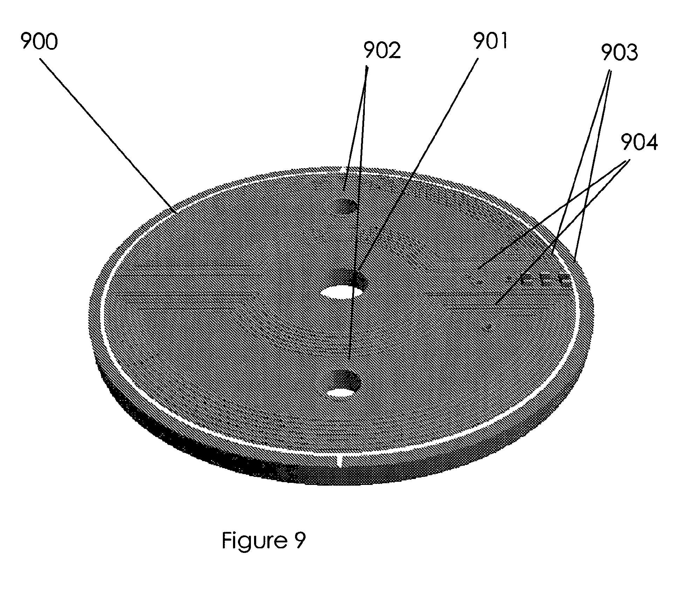

Figure 9 shows a visualisation of the free rotating part of an implementation of the sensor. 900 shows an example track layout. A central hole (901) or fixing holes (902) are used to attach this part of the sensor to the rotating spindle or other object whose rotation is to be measured. The resonant frequency can be set by attaching appropriate values of capacitors (903). Via holes (904) are used to connect to track sections on the other side of the board, to make the necessary connections between the regions without disturbing the connectivity on the side that is visible.

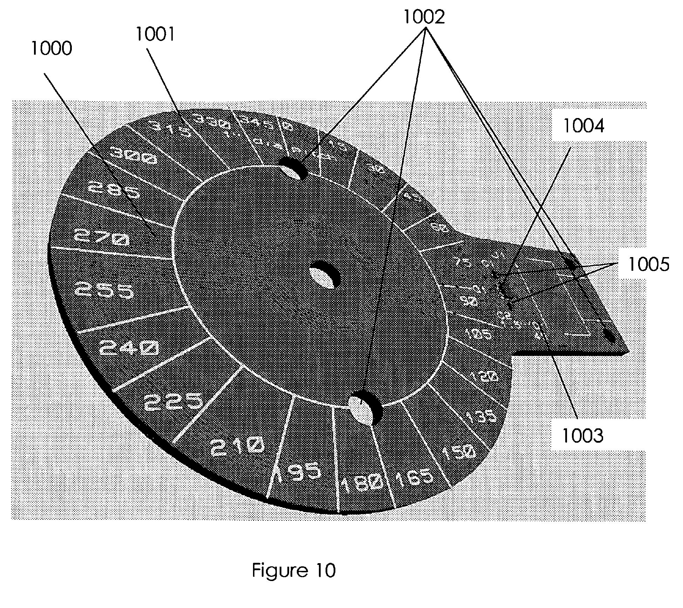

Figure 10 shows a visualisation of the static part of the sensor. (1000) shows an example track layout. (1001) shows graduations that can be useful to set and record differing angular rotational positions when confirming the correct behaviour. Fixing holes (1002) facilitate the mounting of this part of the sensor. In this implementation there is another similar inductive track layout on the other, non visible side of the board. This is displaced by 45 degrees to the one that is visible, to allow quadrature detection. In this implementation transistors (1004) are used to select which of the two track layouts is used for sensing at any time. Capacitors (1006) are used to make the inductive elements resonate. A connector footprint (1003) allows the drive control and sensing circuitry to be connected via appropriate flat flexible cable.

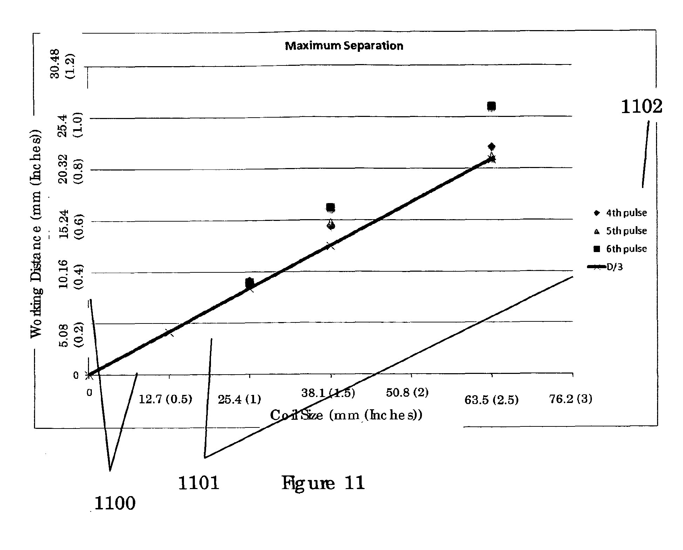

In many possible applications, such as when passing rotations from the wet side to the dry side in a water meter, there will be some barrier or other physical element interposed between the rotating part and the static part. Arranging that the sensor can operate with the widest possible separation between the two parts maximises the number of applications in which it can usefully be deployed. In general larger the inductive track layouts will allow sensing across larger separations. It is also possible to vary the points at which the amplitude is sensed to optimise the maximum detection distance. Figure 11 plots the maximum working distance between static and rotating sensor for an example implementation similar to that shown in the visualisations of Figure 9 and Figure 10, Figure 11 shows how the maximum working distance varied with the inductive track layout diameter and amplitude sampling point. 1101 shows that the maximum working distance remains approximately a linear function of the diameter of the inductive track layouts. In all the cases tested the maximum separation exceeded D/3 where D is diameter of the inductive track layouts. 1102 shows in the implementation tested there is a difference in performance according to the timing of the sensing. The sixth pulse scenario yielded better performance than its fourth and fifth pulse rivals with larger the inductive track layouts.

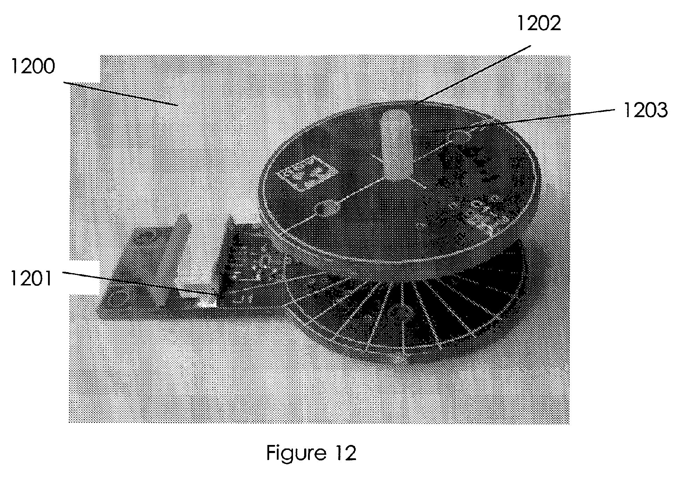

Figure 12 shows a photograph of an example working implementation similar in form to that shown in the visualisations of Figure 9 and figure 10. This includes a free rotating part (1202) which in this example is free to rotate around a central shaft (1203) and a static part (1201).

In embodiments of the invention the rate of flow and direction of flow are detected. Figures 6 and 7 illustrate possible circuitry for carrying out detection. Although Figures 6 and 7 each illustrate one detection channel, generally there will be two detection channels, one for detecting flow rate and one for detecting flow direction. It may however be possible to detect both the rate of flow and the direction of flow using only one detection channel.

## Claims

1. A method for determining the relative coupling between a first (1) and a second (2) relatively movable tuned circuits of similar resonant frequencies by exciting the first (1) tuned circuit at or close to its resonant frequency and detecting or measuring differences between the way that the amplitude of the oscillation in the excited first (1) tuned circuit varies with time and the way that the amplitude would vary with time if there were no coupling between the first (1) and second (2) tuned circuits, wherein coupling is detected by sampling the amplitude of the oscillation at at least two successive times following a perturbation in the excitation signal applied to the first tuned circuit.

2. A method according to claim 1 wherein the excitation signal is applied to the excited tuned circuit.

3. A method according to any preceding claim in which the excitation signal is in the form of a burst of pulses at or close to the resonant frequency and the relative coupling is detected by comparing the amplitudes of the excited oscillation at two fixed but different times after the start of the burst of exciting pulses.

4. A method according to claim 3 in which the comparison is a simple test of which of the two amplitude samples is the larger and in which the sampling points are chosen so that the result of the comparison gives a direct indication of whether or not there is a significant degree of coupling between the two tuned circuits.

5. A method according to claim 3 in which the comparison is made by detecting the charging current flowing in a series combination of a diode (706) and a capacitor (707) arranged so that voltage peaks of the oscillation in the driven tuned circuit charge the capacitor if they are higher than previous peaks.

6. A method according to claim 1 in which the tuned circuits (1, 2) are adjacent and the geometry of inductors in the tuned circuits is arranged so that the magnetic coupling between them varies with the relative physical position of an inductor (3, 4) in the first circuit (1) with respect to an inductor (9, 10) in the second circuit (2) so that the variations in coupling between the circuits determined as in claim 1 can be used to establish variations in the relative physical position of the two tuned circuits (1, 2).

7. A method according to claim 6 in which the inductors (3, 4, 9, 10) are arranged so that the magnetic coupling between them varies with their relative rotational position or with the linear displacement between them so that variations in coupling between the circuits (1, 2) determined as in claim 1 can be used to establish variations in the relative rotational position or the relative linear displacement respectively of the two circuits.

8. A method according to claim 1 in which inductors in the first and second circuits are arranged to provide different regions in which current flow through the inductor is arranged to generate magnetic flux in opposite directions so that at any significant distance away the flux components from the different regions largely cancel and the net flux is low and the influence of externally applied fields on the oscillations is minimised.

9. A method according to claim 1 in which inductive elements in the first and second circuits are made directly by printed circuit board tracking.

10. A method according to claim 1 in which inductors in the first and second circuits do not use any significantly high permeability material, so that the behaviour of the circuits cannot be altered by any such material being saturated by applied fields.

11. A method according to claim 1 wherein determining the relative coupling comprises determining whether the difference in the way the amplitude of oscillations varies with time is positive or negative.

12. A meter for measuring the movement of a fluid comprising:
a first movable element (1);
a second movable element (2) arranged to move in response to movement of the fluid;
a excitation signal generator (12) coupled to the first movable element (1) for generating an excitation signal in the first movable element;
control means for determining a measure of coupling between the first and second movable elements according to the method of any of Claims 1 to 11.

13. A meter according to Claim 12 wherein the first and second movable elements (1,2) comprise rotating elements free of magnetic materials.

14. A meter according to Claim 12 or 13 wherein the first and second movable elements (1,2) comprise inductive coils (3, 4, 9, 10).

## Patentansprüche

1. Verfahren zum Ermitteln der relativen Kopplung zwischen einer ersten (1) und einer zweiten (2) relativ beweglichen abgestimmten Schaltung mit ähnlichen Resonanzfrequenzen durch Anregen der ersten (1) abgestimmten Schaltung auf oder nahe ihrer Resonanzfrequenz und Erkennen oder Messen von Differenzen zwischen der Art und Weise, in der die Amplitude der Oszillation in der angeregten ersten (1) abgestimmten Schaltung über die Zeit variiert, und der Art und Weise, in der die Amplitude über die Zeit variieren würde, wenn es keine Kopplung zwischen der ersten (1) und der zweiten (2) abgestimmten Schaltung gäbe, wobei das Koppeln durch Abtasten der Amplitude der Oszillation zu wenigstens zwei aufeinander folgenden Zeitpunkten nach einer Störung in dem an die erste abgestimmte Schaltung angelegten Anregungssignal erkannt wird.

2. Verfahren nach Anspruch 1, wobei das Anregungssignal an die angeregte abgestimmte Schaltung angelegt wird.

3. Verfahren nach einem vorherigen Anspruch, wobei das Anregungssignal in Form eines Bursts von Impulsen auf oder nahe der Resonanzfrequenz vorliegt und die relative Kopplung durch Vergleichen der Amplituden der angeregten Oszillation zu zwei festen, aber unterschiedlichen Zeitpunkten nach Beginn des Bursts von Anregungsimpulsen erkannt wird.

4. Verfahren nach Anspruch 3, wobei der Vergleich eine einfache Prüfung ist, welche der beiden Amplitudenabtastproben größer ist, und wobei die Abtastpunkte so gewählt werden, dass das Ergebnis des Vergleichs eine direkte Anzeige gibt, ob es einen signifikanten Kopplungsgrad zwischen den beiden abgestimmten Schaltungen gibt oder nicht.

5. Verfahren nach Anspruch 3, wobei der Vergleich durch Erkennen des in einer Serienkombination aus einer Diode (706) und einem Kondensator (707) fließenden Ladestroms erfolgt, so ausgelegt, dass Spannungsspitzen der Oszillation in der angetriebenen Ladung der abgestimmten Schaltung den Kondensator laden, wenn sie höher sind als vorherige Spitzen.

6. Verfahren nach Anspruch 1, wobei die abgestimmten Schaltungen (1, 2) nebeneinander liegen und die Geometrie von Induktoren in den abgestimmten Schaltungen so ausgelegt ist, dass die magnetische Kopplung zwischen ihnen mit der relativen physischen Position eines Induktors (3, 4) in der ersten Schaltung (1) in Bezug auf einen Induktor (9, 10) in der zweiten Schaltung (2) variiert, so dass die Kopplungsvariationen zwischen den Schaltungen wie in Anspruch 1 ermittelt zum Feststellen von Variationen der relativen physischen Position der beiden abgestimmten Schaltungen (1, 2) benutzt werden können.

7. Verfahren nach Anspruch 6, wobei die Induktoren (3, 4, 9, 10) so ausgelegt sind, dass die magnetische Kopplung dazwischen mit ihrer relativen Drehposition oder mit der linearen Verschiebung dazwischen variiert, so dass Kopplungsvariationen zwischen den Schaltungen (1, 2) wie in Anspruch 1 ermittelt zum Feststellen von Variationen der relativen Drehposition bzw. der relativen linearen Verschiebung der beiden Schaltungen benutzt werden können.

8. Verfahren nach Anspruch 1, wobei Induktoren in der ersten und zweiten Schaltung so ausgelegt sind, dass sie unterschiedliche Regionen bereitstellen, in denen Stromfluss durch den Induktor Magnetfluss in entgegengesetzten Richtungen erzeugen kann, so dass sich in einer beliebigen signifikanten Entfernung die Flusskomponenten von den unterschiedlichen Regionen weitgehend löschen und der Nettofluss niedrig ist und der Einfluss von extern angelegten Feldern auf die Oszillationen minimiert wird.

9. Verfahren nach Anspruch 1, wobei induktive Elemente in der ersten und zweiten Schaltung direkt durch Leiterplattentrassierung erzeugt werden.

10. Verfahren nach Anspruch 1, bei dem Induktoren in der ersten und zweiten Schaltung kein Material mit signifikant hoher Permeabilität benutzen, so dass das Verhalten der Schaltungen nicht dadurch verändert werden kann, dass ein solches Material durch angelegte Felder gesättigt wird.

11. Verfahren nach Anspruch 1, wobei das Ermitteln der relativen Kopplung das Ermitteln beinhaltet, ob die Differenz in der Art und Weise, in der die Amplitude von Oszillationen variiert, zeitlich positiv oder negativ ist.

12. Messgerät zum Messen der Bewegung eines Fluids, das Folgendes umfasst:
ein erstes bewegliches Element (1);
ein zweites bewegliches Element (2), so ausgelegt, dass es sich als Reaktion auf Bewegungen des Fluids bewegt;
einen Anregungssignalgenerator (12), der mit dem ersten beweglichen Element (1) gekoppelt ist, um ein Anregungssignal in dem ersten beweglichen Element zu erzeugen;
Steuermittel zum Ermitteln eines Kopplungsgrades zwischen dem ersten und zweiten beweglichen Element gemäß dem Verfahren nach einem der Ansprüche 1 bis 11.

13. Messgerät nach Anspruch 12, wobei das erste und zweite bewegliche Element (1, 2) rotierende Elemente umfassen, die frei von magnetischen Materialien sind.

14. Messgerät nach Anspruch 12 oder 13, wobei das erste und zweite bewegliche Element (1, 2) induktive Spulen (3, 4, 9, 10) umfassen.

## Revendications

1. Procédé de détermination du couplage relatif entre des premier (1) et second (2) circuits accordés relativement mobiles aux fréquences harmoniques similaires en excitant le premier (1) circuit accordé à ou près de sa fréquence de résonance et en détectant ou mesurant des différences entre la façon dont l'amplitude de l'oscillation dans le premier (1) circuit accordé excité varie dans le temps et la façon dont l'amplitude varierait dans le temps en l'absence de couplage entre les premier (1) et second (2) circuits accordés, dans lequel le couplage est détecté en échantillonnant l'amplitude de l'oscillation à au moins deux instants successifs après une perturbation du signal d'excitation appliqué au premier circuit accordé.

2. Procédé selon la revendication 1, dans lequel le signal d'excitation est appliqué au circuit accordé excité.

3. Procédé selon l'une quelconque des revendications précédentes, dans lequel le signal d'excitation a la forme d'une salve d'impulsions à ou près de la fréquence de résonance et le couplage relatif est détecté en comparant les amplitudes de l'oscillation excitée à deux instants fixes mais différents après le début de la salve d'impulsions d'excitation.

4. Procédé selon la revendication 3, dans lequel la comparaison est un simple test déterminant celui des deux échantillons d'amplitude qui est le plus grand et dans lequel les points d'échantillonnage sont choisis de telle sorte que le résultat de la comparaison donne une indication directe de l'existence ou non d'un important degré de couplage entre les deux circuits accordés.

5. Procédé selon la revendication 3, dans lequel la comparaison est effectuée en détectant le courant de charge qui passe dans une combinaison série d'une diode (706) et d'un condensateur (707) agencés de telle sorte que des pics de tension de l'oscillation dans le circuit accordé entraîné chargent le condensateur s'ils sont supérieurs à des pics antérieurs.

6. Procédé selon la revendication 1, dans lequel les circuits accordés (1, 2) sont adjacents et la géométrie de bobines d'induction dans les circuits accordés est agencée de telle sorte que le couplage magnétique entre elles varie avec la position physique relative d'une bobine d'induction (3, 4) dans le premier circuit (1) relativement à une bobine d'induction (9, 10) dans le second circuit (2) de telle sorte que les variations de couplage entre les circuits déterminées à la revendication 1 puissent être utilisées pour établir des variations de la position physique relative des deux circuits accordés (1, 2).

7. Procédé selon la revendication 6, dans lequel les bobines d'induction (3, 4, 9, 10) sont agencées de telle sorte que le couplage magnétique entre elles varie avec leur position angulaire relative ou avec le déplacement linéaire entre elles de telle sorte que les variations de couplage entre les circuits (1, 2) déterminées à la revendication 1 puissent être utilisées pour établir des variations de la position angulaire relative ou du déplacement linéaire relatif respectivement des deux circuits.

8. Procédé selon la revendication 1, dans lequel les bobines d'induction dans les premier et second circuits sont agencées pour fournir différentes régions dans lesquelles le flux de courant à travers la bobine d'induction est agencé pour générer un flux magnétique dans des sens opposés de telle sorte qu'à toute distance importante les composantes de flux provenant des différentes régions s'annulent en grande partie et que le flux net soit faible et que l'influence de champs appliqués extérieurement sur les oscillations soit minimisée.

9. Procédé selon la revendication 1, dans lequel des éléments inductifs dans les premier et second circuits sont réalisés directement par des pistes de carte de circuit imprimé.

10. Procédé selon la revendication 1, dans lequel les bobines d'induction dans les premier et second circuits n'utilisent pas de matériau de grande perméabilité, de telle sorte que le comportement des circuits de telle sorte que les circuits ne puissent pas être modifié par la saturation d'un tel matériau par les champs appliqués.

11. Procédé selon la revendication 1, dans lequel la détermination du couplage relatif comprend la détermination que la différence dans la façon dont l'amplitude des oscillations varie dans le temps est positive ou négative.

12. Compteur pour mesurer le mouvement d'un fluide comprenant :
un premier élément mobile (1) ;
un second élément mobile (2) agencé pour se déplacer en réponse à un mouvement du fluide ;
un générateur de signal d'excitation (12) couplé au premier élément mobile (1) pour générer un signal d'excitation dans le premier élément mobile ;
un moyen de commande pour déterminer une mesure de couplage entre les premier et second éléments mobiles conformément au procédé selon l'une quelconque des revendications 1 à 11.

13. Compteur selon la revendication 12, dans lequel les premier et second éléments mobiles (1, 2) comprennent des éléments rotatifs dépourvus de matériaux magnétiques.

14. Compteur selon la revendication 12 ou 13, dans lequel les premier et second éléments mobiles (1, 2) comprennent des bobines d'induction (3, 4, 9, 10).
